# EUROPÄISCHE PATENTANMELDUNG

(11) **EP 1 231 551 A2**
(43) Veröffentlichungstag der Anmeldung: **14.08.2002**
(21) Anmeldenummer: 02002387.5
(22) Anmeldetag: 31.01.2002
(51) Int. Cl.: G06F 17/50, G06F 11/26, H01L 21/66

(54) **Verfahren zum Simulieren von Fehlern, die bei der Herstellung integrierter Schaltkreise auftreten können, sowie zugehörige Komponenten**

(30) Priorität: 07.02.2001 DE 10105496
(71) Anmelder: Infineon Technologies AG, 81669 München (DE)
(72) Erfinder: Holmer, Rainer, Dr., 94377 Steinach (DE)
(74) Vertreter: Kindermann, Peter, Dipl.-Ing.

(57) **Zusammenfassung**

Erläutert wird ein Verfahren, bei dem Daten (106) zur Beschreibung des Layouts einer Schicht eines integrierten Schaltkreises vorgegeben werden. Mit Hilfe eines Zufallsverfahrens werden automatisch Fehlerstellen im Layout ermittelt, an denen Unterbrechungen oder Verbindungen von Layoutstrukturen bei der Herstellung des Layouts auftreten können (Schritt 104). Außerdem wird automatisch eine Liste (70) mit den ermittelten Fehlerstellen erzeugt.

## Beschreibung

Die Erfindung betrifft ein Verfahren, bei dem Daten zur Beschreibung des Layouts einer Schicht eines integrierten Schaltkreises vorgegeben werden.

Das Layout wurde in einem Entwurfsprozess entworfen und legt die Lage von Schaltungsstrukturen fest. Beispielsweise wird das Layout mit Hilfe der Daten in einer Grafikdatei festgelegt. Ein verbreitetes Grafikformat für das Festlegen von Layouts ist das Format GDSII (Graphic Design System), das unter anderem von dem Programm Cadence Framework genutzt wird.

Zur Herstellung eines integrierten Schaltkreises sind beispielsweise fünf bis sieben Schichten auf ein Halbzeug aufzubringen, z.B. auf eine Halbleiterscheibe, die auch als Wafer bezeichnet wird und beispielsweise Silizium enthält. Bei der Herstellung jeder Schicht wird ausgehend von dem Layout für diese Schicht beispielsweise eine Maske hergestellt, die anschließend in einem Fotolithografieprozess zur Strukturierung einer auf dem Wafer aufgebrachten Schicht dient. Im Rahmen des Fotolithografieprozesses wird auf den Wafer Fotolack aufgebracht, der Fotolack wird gemäß der durch das Layout vorgegebenen Strukturen belichtet. Nach dem Belichten wird die Oberfläche des Wafers mit Hilfe eines Ätzprozesses strukturiert. Außerdem werden zur Herstellung des integrierten Schaltkreises Hilfsschritte durchgeführt, wie Reinigen und Trocknen des Wafers. Herstellungsprozesse mit bis zu 300 Prozessschritten sind üblich.

Am Ende des Fertigungsprozesses werden die gefertigten integrierten Schaltkreise in einer Prüfmaschine automatisch geprüft. Zum Prüfen werden vorgegebene Testeingangsvektoren verwendet, die Eingangssignale beschreiben, die an bestimmte Anschlüsse des integrierten Schaltkreises anzulegen sind. An vorgegebenen Messpunkten werden die sich einstellenden Signale erfasst und als Testausgangsvektoren gespeichert. Die Testausgangsvektoren werden dann mit Soll-Testausgangsvektoren verglichen. Weichen die Testausgangsvektoren von den Soll-Testausgangsvektoren ab, so liegt ein Fehler vor. Bei herkömmlichen Testverfahren lässt sich ein bestimmtes Fehlerbild nicht oder nur sehr schwer zu einer Fehlerursache in einem bestimmten Prozessschritt zuordnen. Deshalb muss beispielsweise zur Eingrenzung der Fehlerursache der integrierte Schaltkreis mit Hilfe einer aufwendigen und teuren Elektronenmikroskopaufnahme untersucht werden.

Es ist Aufgabe der Erfindung, zum Simulieren von Fehlern und/oder zum Lokalisieren von Fehlern in integrierten Schaltkreisen ein einfaches Verfahren anzugeben, mit dem insbesondere Fehler mit einem vergleichsweise geringen rechentechnischen Aufwand simuliert und/oder lokalisiert werden können. Außerdem sollen ein zugehöriges Programm, eine zugehörige Datenverarbeitungsanlage und zugehörige Testergebnisvektoren angegeben werden.

Die auf das Verfahren bezogene Aufgabe wird durch die im Patentanspruch 1 angegebenen Verfahrensschritte gelöst. Weiterbildungen sind in den Unteransprüchen angegeben.

Beim erfindungsgemäßen Verfahren werden zusätzlich zu der Vorgabe der Daten zur Beschreibung des Layouts im Layout mit Hilfe eines Zufallsverfahrens automatisch Fehlstellen ermittelt, an denen Unterbrechungen oder Verbindungen von Layoutstrukturen bei der Herstellung des Layouts auftreten können. Außerdem wird automatisch eine Liste mit den ermittelten Fehlstellen erzeugt.

Die Erfindung geht von der Überlegung aus, dass viele Fehler bei der Herstellung integrierter Schaltkreise ihre Ursache in Zufallsprozessen haben. Beispielsweise sind viele Fehler auf die selbst bei Reinraumbedingungen unvermeidliche Ablagerung von Teilchen auf dem Wafer zurückzuführen. Der genaue Ort, an dem sich ein Teilchen ablagern wird, ist nicht vorausberechenbar. Jedoch lässt sich die Verteilung der Teilchen mit Hilfe von Zufallsprozessen beschreiben und nachbilden. Andere Fehler werden durch Rückstände oder Ablagerungen des Ätzprozesses verursacht.

Durch das erfindungsgemäße Verfahren wird ohne weitere Einbeziehung von Bedienpersonen eine Liste erzeugt, die zur Verbesserung des Entwurfs und/oder für den automatischen Test von integrierten Schaltkreisen verwendbar ist. Das Verfahren zum Erzeugen der Liste und damit zum Simulieren von Fehlern ist schon mit einfacher Rechentechnik in kurzer Zeit auszuführen, weil das Zufallsverfahren mit Hilfe eines einfachen Modells ausführbar ist und weil Unterbrechungen oder Verbindungen von Layoutstrukturen mit Hilfe von einfachen Methoden der Bildbearbeitung aus den Daten zur Beschreibung des Layouts ermittelt werden können.

Das Fehlersimulationsverfahren lässt sich unabhängig davon ausführen, ob die Layoutstrukturen zur Herstellung eines analogen oder eines digitalen Schaltkreises dienen sollen. Insbesondere für analoge Schaltkreise lassen sich unter Verwendung dieser Fehlersimulation Testverfahren ausführen, die bisher bekannten Testverfahren weit überlegen sind, z.B. hinsichtlich der Testzeit und der Treffsicherheit. Bei analogen Schaltungen, z.B. bei Operationsverstärkern, wird die zu bearbeitende Information durch einen kontinuierlichen Signalbereich dargestellt. Bei digitalen Schaltungen gibt es dagegen nur diskrete Werte zur Darstellung der Information, z.B. die Werte 0 Volt und 5 Volt.

Bei einer Weiterbildung des erfindungsgemäßen Verfahrens wird die Liste zur Verbesserung des Layouts verwendet. Bei einer Ausgestaltung wird automatisch eine Rangliste einzelner Gebiete des Layouts abhängig von der Flächendichte der ermittelten Fehlerstellen erstellt. Gebiete, an denen die Flächendichte der Fehlerstellen sehr hoch ist, werden wahrscheinlich die Ursache von Fehlern bei der Herstellung des integrierten Schaltkreises sein. Deshalb sollte gerade an diesen Stellen der Entwurf des Layouts neu überdacht werden. Möglicherweise lassen sich später Fehler vermeiden, wenn die Layoutstrukturen etwas umgeordnet werden.

Bei einer anderen Weiterbildung des erfindungsgemäßen Verfahrens wird automatisch die Gesamtfläche der Gebiete des Layouts ermittelt, in denen die Flächendichte der ermittelten Fehlerstellen einen vorgegebenen Schwellwert überschreitet. Diese Gesamtfläche wird auch als kritische Chipfläche bezeichnet. Die ermittelte Gesamtfläche wird automatisch mit einem vorgegebenen Grenzwert verglichen. Abhängig vom Vergleichsergebnis wird automatisch ein Hinweis für eine Bedienperson erzeugt. Die Bedienperson wird den Entwurf überarbeiten, wenn die ermittelte Gesamtfläche den vorgegebenen Grenzwert überschreitet. Liegt dagegen die ermittelte Gesamtfläche unterhalb des vorgegebenen Grenzwertes, so muss der Entwurf vorerst nicht überarbeitet werden. Sowohl der Schwellwert als auch der Grenzwert lassen sich empirisch vorgeben. Dabei muss darauf geachtet werden, dass auf der einen Seite der Schwellwert bzw. Grenzwert nicht zu klein ist, da sonst eine Überreaktion entsteht. Andererseits sollten der Schwellwert und der Grenzwert auch nur so groß gewählt werden, dass letztlich die bei der Herstellung tatsächlich auftretenden Fehler verringert werden, weil die Bedienperson gegebenenfalls zur Überarbeitung des Entwurfs veranlasst wird.

Die Liste lässt sich bei einer alternativen Weiterbildung jedoch auch für den automatischen Test von integrierten Schaltkreisen einsetzen. Abhängig von den ermittelten Fehlerstellen werden ausgehend von Daten zur Beschreibung der elektrischen Schaltung des integrierten Schaltkreises Fehlerdaten erzeugt. Ausgehend von für den jeweiligen integrierten Schaltkreis vorgegebenen Testeingangsvektoren zum Test eines Schaltungsmodells des integrierten Schaltkreises oder zum Test des integrierten Schaltkreises selbst werden mit Hilfe der Fehlerdaten Testergebnisvektoren berechnet und für die spätere Prüfung gespeichert. Beim Test des integrierten Schaltkreises werden dann die Testergebnisvektoren verwendet.

Die elektronische Schaltung des integrierten Schaltkreises wird mit Hilfe von sogenannten Netzlisten beschrieben, in denen die zwischen bestimmten Schaltungsknoten liegenden elektronischen Bauelemente aufgelistet sind. Mit Hilfe von Bibliotheken, in denen die elektrischen Kenngrößen der Bauelemente gespeichert sind, lässt sich dann die Funktion des Schaltkreises simulieren. Ein verbreitetes Programm zur Simulation der Funktion integrierter Schaltkreise ist das Programm SPICE (Simulation Programm For Integrated Circuits Emphasis).

Betrifft eine Fehlerstelle eine Unterbrechung, so wird die Netzliste so verändert, dass die der unterbrochenen Layoutstruktur entsprechende Leitung im Schaltungsmodell ebenfalls unterbrochen ist. Andererseits wird bei einer Fehlerstelle, die durch eine Verbindung zweier Layoutstrukturen entsteht, die Beschreibung der elektrischen Schaltung so verändert, dass Leitungen zur Modellierung der beiden Layoutstrukturen im Schaltungsmodell verbunden werden.

Durch diese Herangehensweise wird es möglich, ausgehend von einem bekannten Fehler die Auswirkung auf die Funktion der Schaltung zu ermitteln. Dieser Weg ist einfacher als die bisher durchgeführte Ermittlung von Fehlerursachen ausgehend von einem defekten integrierten Schaltkreis. Bei der Weiterbildung lässt sich die Fehlerursache nämlich durch einen Vergleich von tatsächlich erfassten Testausgangsvektoren mit den abhängig von Fehlern generierten Testergebnisvektoren ermitteln.

Bei einer Weiterbildung werden die Testergebnisvektoren mit Soll-Testausgangsvektoren verglichen, die bei fehlerfreien Schaltkreisen auftreten. Für den Test des integrierten Schaltkreises werden nur solche Testergebnisvektoren gespeichert, die von den Soll-Testausgangsvektoren abweichen. Nur diese Testergebnisvektoren sind charakteristisch für bestimmte Fehler. Durch die Vorauswahl der Testergebnisvektoren wird erreicht, dass die in der Vergleichsdatenbank zu speichernde Datenmenge vergleichsweise klein ist. Dies ermöglicht die schnelle Durchführung von Testverfahren.

Bei einer nächsten Weiterbildung werden zu den Testvektoren auch die zugehörigen Unterbrechungen oder Verbindungen gespeichert. Insbesondere wird hinterlegt, in welcher Schicht und an welchem Ort innerhalb der Schicht die Fehlstelle liegt. Treten dann bei der Produktion der integrierten Schaltkreise wiederholt Fehler auf, deren Fehlerursache wahrscheinlich durch die gleiche Fehlerstelle verursacht worden ist, so lässt sich durch die genaue Bestimmung der Schicht bereits eindeutig auf bestimmte Prozessschritte schließen, in denen die Fehlerursache zu suchen ist. Die Suche nach der Fehlerursache kann durch diese Vorgehensweise erheblich eingegrenzt werden. Hochspezialisierte Bedienpersonen benötigen deshalb für die Suche der Fehlerursache erheblich weniger Zeit.

Bei einer nächsten Weiterbildung werden beim Test von integrierten Schaltkreisen erfasste Testausgangsvektoren mit den Testergebnisvektoren verglichen. Übereinstimmungen werden automatisch vermerkt. Die vermerkten Übereinstimmungen werden zur gezielten Beeinflussung des Designs verwendet. Durch diese Maßnahme lässt sich das Design abhängig von tatsächlich auftretenden Fehlern beeinflussen, die mit zuvor simulierten Fehlern übereinstimmen. Diese Maßnahme ist besonders geeignet, um nach einem Probeproduktionslauf mit kleinen Stückzahlen den Entwurf noch etwas zu verbessern und so die Ausbeute bei der Massenproduktion der integrierten Schaltkreise um entscheidende Prozentpunkte zu erhöhen.

Bei einer nächsten Weiterbildung des erfindungsgemäßen Verfahrens beruht das Zufallsverfahren auf einer vorgegebenen Verteilung für eine statistische Größe. So wird bei einer Ausgestaltung eine Binominalverteilung genutzt, welche die Anzahl und/oder die Größe von Teilchen auf einer bestimmten Fläche eines integrierten Schaltkreises abhängig vom Ort beschreibt. Es werden jedoch auch andere geeignete Verteilungen eingesetzt, z.B. eine Poisson-Verteilung.

Zur Simulation der Fehler werden bei einer anderen Weiterbildung Daten eingesetzt, die bei der Herstellung von integrierten Schaltkreisen in der Produktion erfasst worden sind und welche die Art und die Anzahl der Defekte verursachenden Teilchen beschreiben. Beispielsweise kann ein Testwafer die Produktion durchlaufen, auf dem anschließend mit empfindlicher Messtechnik die Teilchen erfasst werden, die sich während des Durchlaufens der Produktion abgelagert haben, oder die Reste von Schichten, die beim Ätzen in den betreffenden Bereichen eigentlich vollständig entfernt werden sollten. Durch diese Maßnahme lässt sich das dem Zufallsverfahren zugrundeliegende Modell an die tatsächlichen Produktionsbedingungen durch die Wahl geeigneter Parameter anpassen.

Die Erfindung betrifft außerdem ein Programm mit einer Befehlsfolge, bei deren Ausführung durch einen Prozessor das erfindungsgemäße Verfahren oder eine seiner Weiterbildungen durchgeführt wird. Das Programm ist beispielsweise Bestandteil eines Entwurfsprogramms, mit dessen Hilfe sich Layouts für integrierte Schaltkreise entwerfen lassen. Außerdem betrifft die Erfindung eine Datenverarbeitungsanlage, die das erfindungsgemäße Programm enthält. Weiterhin bezieht sich die Erfindung auf die Testergebnisvektoren, die mit Hilfe des erfindungsgemäßen Verfahrens oder einer seiner Weiterbildungen erzeugt werden. Für das Programm, für die Datenverarbeitungsanlage und für die Testergebnisvektoren gelten die oben genannten technischen Wirkungen ebenfalls.

Im Folgenden werden Ausführungsbeispiele der Erfindung an Hand der beiliegenden Zeichnungen erläutert. Darin zeigen:
- Figur 1: ein Layout eines integrierten Schaltkreises mit simulierten Fehlerstellen,
- Figur 2: Verfahrensschritte zur Designverbesserung durch Fehlersimulation,
- Figur 3: Verfahrensschritte zum Testen von integrierten Schaltkreisen unter Einbeziehung einer Fehlersimulation, und
- Figur 4: die Darstellung des Zusammenhangs zwischen Ausbeute und kritischer Chipfläche.

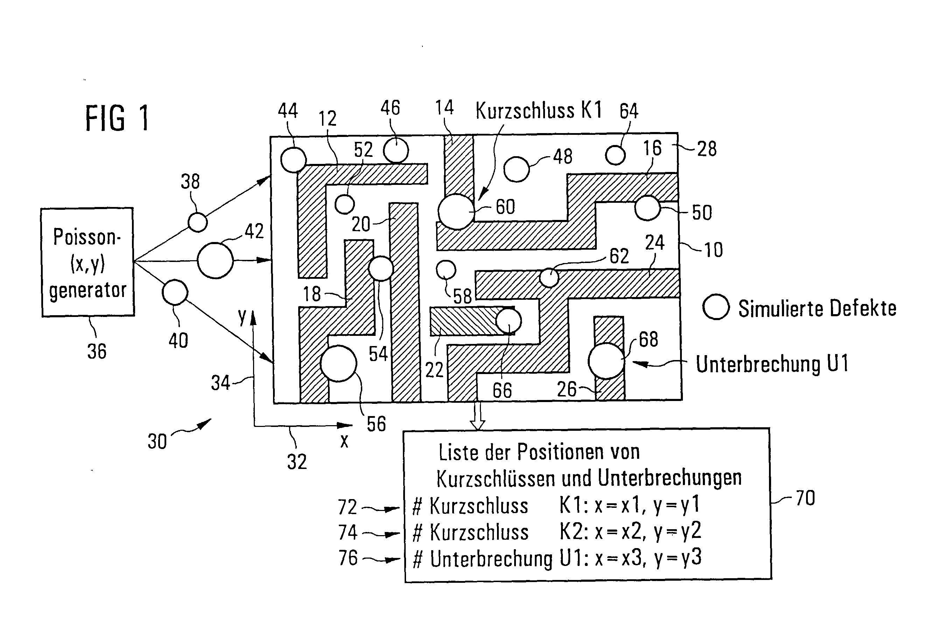

Figur 1 zeigt ein Layout 10 eines integrierten Schaltkreises mit simulierten Fehlerstellen. Das Layout 10 wird durch Daten in einem Grafikformat beschrieben. Diese Daten sind beispielsweise die Eingangsdaten eines Maskenschreibers, mit dessen Hilfe die Maske zur Herstellung des Layouts 10 erzeugt wird. Das Layout 10 enthält dunkle Layoutstrukturen 12 bis 26, die durch helle Gebiete 28 voneinander getrennt sind. Die Daten beschreiben die Lage der dunklen Layoutstrukturen 12 bis 26 bezüglich eines Bezugskoordinatensystems 30, das eine horizontal verlaufende x-Achse 32 und eine vertikal verlaufende y-Achse 34 hat. Außerdem beschreiben die Daten die Form der dunklen Layoutstrukturen 12 bis 26, insbesondere deren Breite in bestimmten Teilabschnitten. Die Layoutstrukturen 12 bis 26 verlaufen gerade, d.h. sie bilden Rechtecke, oder sind einmal oder mehrmals jeweils um 90° abgewinkelt. Bei anderen Ausführungsbeispielen werden andere Strukturen simuliert, z.B. spiralförmige oder gekrümmte Strukturen. Aufgrund der verschiedenen Strukturen der dunklen Layoutstrukturen 12 bis 26 sind die Abstände zwischen benachbarten Layoutstrukturen 12 bis 26 ortsabhängig.

Mit Hilfe eines Zufallsgenerators 36 werden die Daten so ergänzt, dass bei einer Darstellung der durch die Daten beschriebenen Strukturen auf dem Layout 10 Kreise 38, 40 und 42 mit verschiedenen Durchmessern angeordnet sind. Der Zufallsgenerator 36 ordnet die Kreise gemäß einer vorgegebenen Poissonverteilung an bestimmten x-, y-Positionen an. Die Kreise 38 bis 42 haben Durchmesser, die den Durchmessern von Teilchen oder Strukturierungsresten entsprechen, welche die Fertigung stören. Die Poissonverteilung wird so vorgegeben, dass die Verteilung der Kreise 38 bis 42 auf dem Layout 10 der Verteilung von Teilchen unterschiedlicher Größe auf einem Wafer während des Fertigungsprozesses entspricht. Im Layout 10 sind eine Vielzahl von Kreisen 44 bis 68 angeordnet, die eine stark übertriebene Verunreinigung simulieren. Der größte Durchmesser der Kreise 44 bis 68 entspricht etwa der mittleren Breite der dunklen Layoutstrukturen 12 bis 26.

Die Kreise 44 bis 68 werden mit Hilfe des Zufallsgenerators 36 auf zufällige Weise angeordnet. Auch die Auswahl der Durchmesser der Kreise ist durch eine vorgegebene Zufallsfunktion bestimmt. Die Kreise 44 bis 68 werden durch Daten in dem Grafikformat beschrieben, das auch zur Darstellung des Layouts 10 genutzt wird. Mit den aus der Bildverarbeitung bekannten Methoden lässt sich ermitteln, an welchen Stellen die Kreise 44 bis 68 zwei dunkle Leitungsstrukturen 12 bis 26 verbinden, siehe beispielsweise die Kreise 54 bzw. 60, welche die Leitungsstrukturen 18 und 20 bzw. die Leitungsstrukturen 14 und 16 miteinander verbinden. Gemäß vorgegebener Simulationsregeln stellt eine solche Verbindung einen Kurzschluss dar, siehe Kurzschluss K1 durch den Kreis 60. Außerdem wird mit Hilfe von aus der Bildbearbeitung bekannten Methoden ermittelt, an welchen Stellen Kreise 44 bis 68 eine Layoutstruktur 12 bis 26 in zwei voneinander getrennte Teilbereiche unterteilen. Dies trifft beispielsweise für den Kreis 68 zu, der die Layoutstruktur 26 unterteilt. Gemäß den Regeln für die Fehlersimulation werden an den so ermittelten Stellen Unterbrechungen erfasst, siehe Unterbrechung U1 für den Kreis 68.

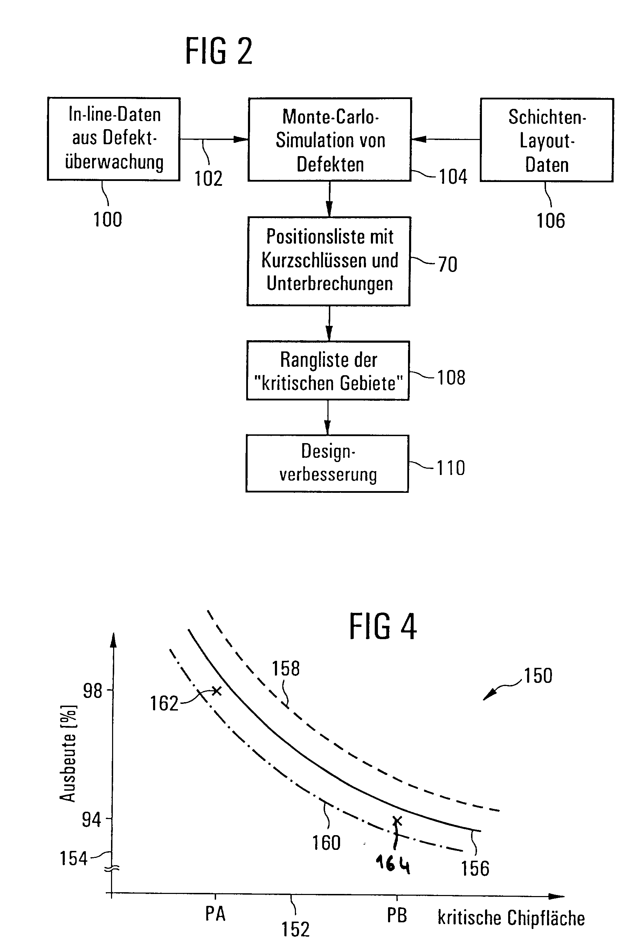

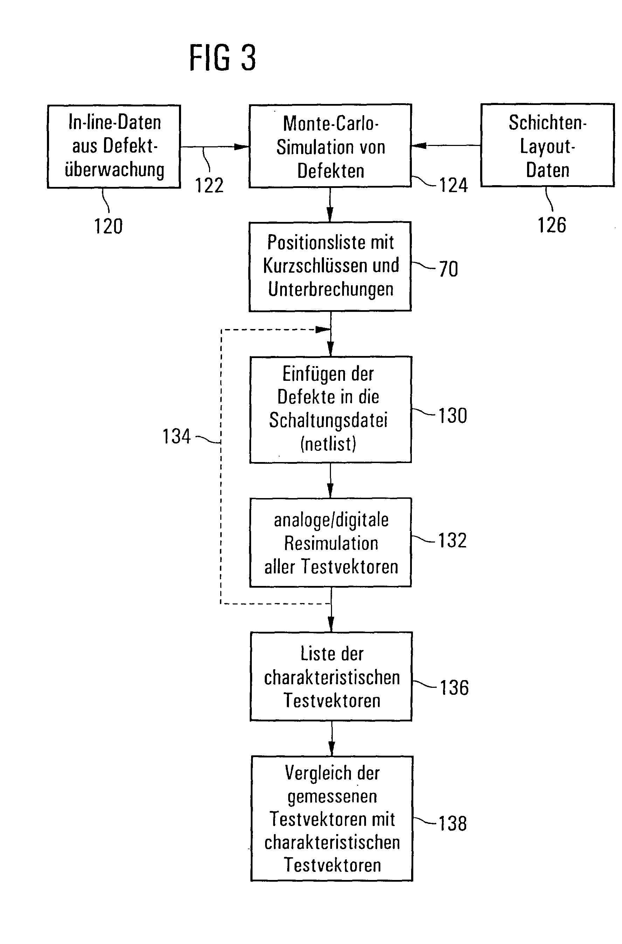

Mit Hilfe eines Programms wird anschließend automatisch eine Liste 70 erzeugt, in der die Positionen von Kurzschlüssen K1, K2 und Unterbrechungen U1 vermerkt sind. Die Liste 70 wird in den unten an Hand der Figuren 2 und 3 erläuterten Verfahren eingesetzt. Die Liste 70 enthält Zeilen 72 bis 76, in denen jeweils ein simulierter Fehler vermerkt ist. Für jeden Kurzschluss K1, K2 und für jede Unterbrechung U1 ist eine Ortskoordinate vermerkt, siehe Koordinatenpaare x1, y1; x2, y2 bzw. x3, y3.

Figur 2 zeigt Verfahrensschritte zur Designverbesserung durch Fehlersimulation. In einem Verfahrensschritt 100 werden aus der Defektüberwachung der Fertigung von integrierten Schaltkreisen sogenannte In-Line-Daten erzeugt, die die Verteilung von Verunreinigungsteilchen mit unterschiedlichem Durchmesser wiedergeben. Zur Ermittlung dieser Daten durchläuft beispielsweise eine Testscheibe die Produktion. Nach dem Durchlaufen wird diese Testscheibe mit einem Laserstrahl abgetastet und es wird die Anzahl von Teilchen mit bestimmten Durchmessern ermittelt. Zum Ermitteln der Teilchen lassen sich auch sogenannte Differenzbildanlagen einsetzen. Mit Hilfe der In-Line-Daten werden dann die Parameter für den Zufallsgenerator 36 festgelegt, siehe Pfeil 102. Die oben an Hand der Figur 1 erläuterte Simulation wird aufgrund der Verwendung eines Zufallsgenerators 36 auch als Monte-Carlo-Simulation bezeichnet, siehe Verfahrensschritt 104. Bei der Simulation im Verfahrensschritt 104 werden, wie auch bereits an Hand der Figur 1 erläutert, Layoutdaten 106 verwendet, die das Layout der Schichten des herzustellenden integrierten Schaltkreises beschreiben.

Ergebnis der Monte-Carlo-Simulation im Verfahrensschritt 104 ist die Liste 70. In einem folgenden Verfahrensschritt 108 wird automatisch mit Hilfe einer Datenverarbeitungsanlage eine Rangliste der sogenannten "kritischen Gebiete" erzeugt, das sind Gebiete, in denen die Anzahl von Fehlern je Fläche einen vorgegebenen Schwellwert überschreitet.

In einem Verfahrensschritt 110 wird die Rangliste in einem Speicher der Datenverarbeitungsanlage gespeichert. Außerdem wird die Rangliste mit Hilfe eines Druckers ausgedruckt. Ausgehend von der Rangliste wird der Entwurf des Layouts verbessert, beispielsweise werden die dunklen Layoutstrukturen in den "kritischen Gebieten" mit größerem Abstand zueinander angeordnet.

Figur 3 zeigt Verfahrensschritte zum Testen von integrierten Schaltkreisen unter Einbeziehung einer Fehlersimulation. Ein Verfahrensschritt 120 entspricht dem Verfahrensschritt 100 und dient zur Ermittlung der Parameter für die Zufallsfunktion, siehe Pfeil 122. Der oben an Hand der Figur 1 erläuterte Simulationsschritt wird durch einen Verfahrensschritt 124 dargestellt. Bei der Monte-Carlo-Simulation im Verfahrensschritt 124 werden Schichten-Layout-Daten 126 des zu fertigenden integrierten Schaltkreises einbezogen. Ergebnis der Simulation im Verfahrensschritt 124 ist wieder die Liste 70, in welcher die Positionen von simulierten Kurzschlüssen K1, K2 und simulierten Unterbrechungen U1 vermerkt sind.

In einem folgenden Verfahrensschritt 130 wird zu jedem in der Liste 70 vermerkten Fehler eine durch diesen Fehler betroffene Leitung bzw. ein durch diesen Fehler betroffenes Bauelement automatisch und/oder manuell ermittelt. Anschließend wird für jeden Fehler einzeln das Modell der elektrischen Schaltung so verändert, das die Schaltung eines durch einen solchen Fehler beeinträchtigten integrierten Schaltkreises nachgebildet wird. Zu der geänderten Schaltungsstruktur wird eine zugehörige Netzliste erzeugt.

Anschließend wird in einem Verfahrensschritt 132 eine analoge bzw. digitale Resimulation mit allen Testeingangsvektoren durchgeführt. Die dabei entstehenden Testergebnisvektoren werden für das spätere Testen von integrierten Schaltkreisen gespeichert. Anschließend wird der nächste in der Liste 70 vermerkte Fehler betrachtet, siehe Pfeil 134.

Die Verfahrensschritte 130 und 132 werden so lange durchlaufen, bis für jeden in der Liste 70 vermerkten Fehler eine Gruppe von Testergebnisvektoren erzeugt worden ist. Ist dies der Fall, so folgt unmittelbar nach dem Verfahrensschritt 132 ein Verfahrensschritt 136, in welchem die Gruppen von Testergebnisvektoren mit einer Gruppe von Soll-Testausgangsvektoren verglichen werden, die bei einem fehlerfrei arbeitenden integrierten Schaltkreis erzeugt werden müsste. Gruppen von Testergebnisvektoren, bei denen Abweichungen von den Soll-Ausgangsvektoren auftreten, werden ausgewählt und für den späteren Test gespeichert. Diese Testvektoren werden auch als charakteristische Testvektoren bezeichnet, weil sie für einen bestimmten Fehler charakteristisch sind, nämlich für den Fehler, für den sie in den Verfahrensschritten 130 und 132 erzeugt worden sind. Außerdem wird zu den Gruppen der Testergebnisvektoren die Layoutschicht und die Position des Fehlers vermerkt.

In einem Verfahrensschritt 138 werden in einem Fertigungsprozess gefertigte integrierte Schaltkreise in einer automatischen Testanlage geprüft. Treten Abweichungen von Testausgangsvektoren zu den Soll-Testausgangsvektoren auf, so wird eine Datenbank durchsucht, in der die charakteristischen Testergebnisvektoren gespeichert sind. Sind die charakteristischen Testergebnisvektoren für einen Fehler den tatsächlich erfassten Testausgangsvektoren gleich, so wird die für diese Testergebnisvektoren vermerkte Schicht und die Position des Fehlers auf einer Anzeigeeinheit der Prüfeinrichtung angezeigt und/oder in einer Fehlerdatei zur späteren manuellen oder automatischen Auswertung gespeichert. Die angezeigten Angaben werden zur Ermittlung desjenigen Fertigungsschrittes genutzt, in dem die Fehlerursache gesucht werden muss, beispielsweise eine nicht ordnungsgemäß arbeitende Filtereinheit zum Reinigen des Umgebungsmediums in dem betreffenden Fertigungsraum.

Figur 4 zeigt die Darstellung des Zusammenhangs zwischen Ausbeute und kritischer Chipfläche in einem Koordinatensystem 150. Eine horizontale Abszissenachse 152 dient zur Darstellung der kritischen Chipfläche. Eine vertikale Ordinatenachse 154 dient zur Darstellung der Ausbeute bei der Chipherstellung, d.h. dem Verhältnis von funktionsfähigen integrierten Schaltkreisen zu der Gesamtzahl von integrierten Schaltkreisen auf einer Halbleiterscheibe. Eine Kurve 156 gibt den Zusammenhang zwischen kritischer Chipfläche und Ausbeute an. Die Kurve 156 hat einen Verlauf, der dem Verlauf einer fallenden Exponentialfunktion entspricht. Die Lage der Kurve 156 im Koordinatensystem 150 ist eine Funktion der im Fertigungsprozess vorhandenen räumlichen Dichte der Verunreinigungen. Bei reineren Fertigungsbedingungen wird die Kurve 156 zu größeren Ausbeuten hin verschoben, siehe gestrichelte Kurve 158. Bei stärkeren Verunreinigungen in der Produktion wird die Kurve 156 zu kleineren Ausbeuten hin verschoben, siehe Strich-Punkt-Kurve 160.

Die kritische Chipfläche ist die Fläche je Chip, auf der die Dichte der mit der Monte-Carlo-Simulation ermittelten Fehler je Flächeneinheit einen vorgegebenen Schwellwert überschreitet. Ein Produkt PA mit einer kleinen kritischen Chipfläche hat beispielsweise eine Ausbeute von 98 %, siehe Kreuz 162. Ein Produkt PB mit einer größeren kritischen Chipfläche als das Produkt PA hat dagegen nur eine Ausbeute von 94 %. Würde man auf der Abszissenachse 152 dagegen wie bisher üblich die Gesamt-Chipfläche der Produkte PA und PB abtragen, so wäre beispielsweise die Gesamt-Chipfläche des Produktes PA größer als die Gesamt-Chipfläche des Produktes PB. Die verringerte Ausbeute bei der Herstellung des Produktes PB ließe sich in diesem Fall nicht erklären.

Die an Hand der Figur 4 dargestellten Zusammenhänge werden bei einem anderen Ausführungsbeispiel automatisch auf einer Anzeigeeinheit dargestellt, um den Designer des Layouts beim Entwurf zu unterstützen. Die kritische Chipfläche ist nämlich ein zur Verbesserung des Entwurfs besonders gut geeignetes Maß.

## Patentansprüche

1. Verfahren zum Simulieren von Fehlern (K1, U1), die bei der Herstellung integrierter Schaltkreise auftreten können,
bei dem Daten (106, 126) zur Beschreibung des Layouts (10) einer Schicht eines integrierten Schaltkreises vorgegeben werden,
bei dem mit Hilfe eines Zufallsverfahrens (Schritt 104, 124) automatisch Fehlerstellen (K1, U1) im Layout (10) ermittelt werden, an denen Unterbrechungen (U1) oder Verbindungen (K1) von Layoutstrukturen (12 bis 26) bei der Herstellung des Layouts auftreten können,
und bei dem automatisch eine Liste (70) mit den ermittelten Fehlerstellen erzeugt wird.

2. Verfahren nach Anspruch 1, **dadurch gekennzeichnet, dass** die Liste (70) zur Verbesserung des Layouts (10) verwendet wird (Schritt 110).

3. Verfahren nach Anspruch 2, **dadurch gekennzeichnet, dass** automatisch eine Rangliste einzelner Gebiete des Layouts abhängig von der Flächendichte der ermittelten Fehlerstellen erstellt wird.

4. Verfahren nach einem der vorhergehenden Ansprüche, **dadurch gekennzeichnet, dass** automatisch die Gesamtfläche der Gebiete des Layouts ermittelt wird, in denen die Flächendichte der ermittelten Fehlerstellen einen vorgegebenen Schwellwert überschreitet.

5. Verfahren nach Anspruch 4, **dadurch gekennzeichnet, dass** die ermittelte Gesamtfläche automatisch mit einem Grenzwert verglichen wird,
und dass abhängig vom Vergleichsergebnis automatisch ein Hinweis für eine Bedienperson erzeugt wird.

6. Verfahren nach Anspruch 1, **dadurch gekennzeichnet, dass** abhängig von den ermittelten Fehlerstellen ausgehend von Daten zur Beschreibung der elektrischen Schaltung des integrierten Schaltkreises Fehlerdaten erzeugt werden (Schritt 130), die eine aufgrund der Fehlerstellen veränderte elektrisch Schaltung des integrierten Schaltkreises beschreiben,
dass ausgehend von vorgegebenen Testvektoren zum Test eines Schaltungsmodells des integrierten Schaltkreises oder zum Test des integrierten Schaltkreises selbst mit Hilfe der Fehlerdaten Testergebnisvektoren berechnet und gespeichert werden (Schritt 132),
und dass die Testergebnisvektoren beim Test des integrierten Schaltkreises verwendet werden (Schritt 138).

7. Verfahren nach Anspruch 6, **dadurch gekennzeichnet, dass** die Testergebnisvektoren mit Soll-Testausgangsvektoren verglichen werden, die bei fehlerfreien Schaltkreisen auftreten,
und dass nur von den Soll-Testausgangsvektoren abweichende Testergebnisvektoren für den Test des integrierten Schaltkreises gespeichert werden (Schritt 136).

8. Verfahren nach Anspruch 6 oder 7, **dadurch gekennzeichnet, dass** zu den Testvektoren auch die zugehörigen Unterbrechungen (U1) oder Verbindungen (K1) und/oder deren Position und/oder die betroffene Schicht gespeichert werden.

9. Verfahren nach einem der Ansprüche 6 bis 8, **dadurch gekennzeichnet, dass** beim Test von integrierten Schaltkreisen erfasste Testausgangsvektoren mit den Testergebnisvektoren verglichen werden,
dass Übereinstimmungen automatisch gespeichert werden,
und dass die gespeicherten Übereinstimmungen zur gezielten Beeinflussung des Designs verwendet werden.

10. Verfahren nach einem der vorhergehenden Ansprüche, **dadurch gekennzeichnet, dass** das Zufallsverfahren (104, 124) auf einer vorgegebenen Verteilung (36) einer statischen Größe beruht.

11. Verfahren nach Anspruch 10, **dadurch gekennzeichnet, dass** die Verteilung eine Binominalverteilung oder eine Poissonverteilung ist, welche die Anzahl und/oder die Größe von Teilchen auf einer bestimmten Fläche des integrierten Schaltkreises zeitunabhängig oder abhängig von der Zeit beschreibt.

12. Verfahren nach einem der vorhergehenden Ansprüche, **dadurch gekennzeichnet, dass** Daten zur Fehlersimulation eingesetzt werden, die bei der Herstellung von integrierten Schaltkreisen in der Produktion erfasst worden sind und die die Art und/oder die Anzahl der Defekte verursachenden Teilchen beschreiben (Schritt 100, 120).

13. Programm mit einer Befehlsfolge, bei deren Ausführung durch einen Prozessor ein Verfahren nach einem der vorhergehenden Ansprüche durchgeführt wird.

14. Datenverarbeitungsanlage, **dadurch gekennzeichnet, dass** die Datenverarbeitungsanlage ein Programm nach Anspruch 13 enthält.

15. Testergebnisvektoren, **dadurch gekennzeichnet , dass** die Testergebnisvektoren mit einem Verfahren nach einem der Ansprüche 6 bis 9 oder 10 bis 12, soweit auf die Ansprüche 6 bis 9 rückbezogen, erzeugt worden sind und/oder in einem solchen Verfahren eingesetzt werden.
